# EUROPEAN PATENT APPLICATION

(11) **EP 1 780 803 A1**
(43) Date of publication of application: **02.05.2007**
(21) Application number: 05077474.4
(22) Date of filing: 28.10.2005
(51) Int. Cl.: H01L 31/18, H01L 21/208

(54) **A method for applying at least one silicon containing layer onto an electron conductive layer**

(71) Applicant: Nederlandse Organisatie voor toegepast-natuurwetenschappelijk Onderzoek TNO, 2628 VK Delft (NL)
(72) Inventor: Bressers, Peter Marinus Martinus Cornelus, 8032 MZ Zwolle (NL); Saakes, Machiel, 7316 BC Apeldoorn (NL)
(74) Representative: Winckels, Johannes Hubertus F.

(57) **Abstract**

The invention provides a method for applying at least one silicon containing layer onto an electron conductive layer by means of electrodeposition from an ionic liquid, which ionic liquid comprises a dissolved silicon salt and a dopant in the form of a dissolved salt.

## Description

The present method relates to a method for applying at least one silicon containing layer onto an electron conductive layer.

Solar cells (also called photovoltaic solar cells) are increasingly being used to convert sunlight into electrical energy. By far the most applied and fabricated solar cells are based on the semiconductor material silicon. Since silicon based solar cells are still relatively expense much research is directed to the development of less expensive cells, enabling the use on a larger scale. In essence, this can be established by making the solar cell either more efficient by using improved materials and/or constructions or by using less material and thus reducing cost. As regards the latter approach, thin-film silicon solar cells have been introduced.

However, the currently available manufacturing processes for producing commercial thin-film silicon solar cells have various drawbacks. The deposition processes used for applying the subsequent layers require high investment costs and highly skilled personnel.

Hence, there is a clear desire to develop a manufacturing method for thin-film silicon solar cells that is much easier to carry out, that does not require high investment costs, highly skilled personnel, and that is faster than the conventional methods.

Object of the present invention is to provide such a method.

Surprisingly, it has now been found that such a method can be realised when at least one silicon containing layer is applied onto an electron conductive layer, whereby the silicon containing layer is prepared by means of electrodeposition from an ionic liquid, which liquid comprises a dopant.

Accordingly, the present invention relates to a method for applying at least one silicon containing layer onto an electron conductive layer by means of electrodeposition from an ionic liquid, which ionic liquid comprises a dissolved silicon salt and a dopant in the form of a dissolved salt.

The method in accordance with the present invention has the advantage that layers can be applied onto large surfaces by means of, for instance, roll-to-roll deposition processes. Moreover, electrodeposition is as such a well-established technique which does not require especially highly skilled personnel and a high investment.

The dopant in the at least one silicon containing layer can be an electron donor or an electron acceptor.

Suitably, the donor to be used in accordance with the present invention comprises a salt of an element from the group V elements, whereas the acceptor comprises a salt of an element from the group III elements.

Preferably, the donor element is P, As, or Sb.

The accepter element is preferably Al or B.

Preferably, the salt of the group V and group III elements is chosen from the group consisting of chlorides, bromides, iodides, nitrates, nitrites, fluorides, phosphates, imides, amides, borates, tosylate, tetrafluoroborate, hexafluoroborate, hexafluorophosphate, trifluoromethanesulfonate, methylsulfate, bis(pentafluoroethyl)phosphinate, thiocynate, octylsulfate, hexylsulfate, buthylsulfate, ethylsulfate, dicyanamide, hexafluoroantimonate, bis-(pentafluoroethyl)phospinate, bis-(trifluoromethyl)imide, trifluoroacetate and dicyanamide.

In the at least one silicon containing layer one or more different donors or one or more different acceptors can be used.

Preferably, the silicon containing layer comprises a silicon salt chosen from the group consisting of chlorides, bromides, iodides, nitrates, nitrites, fluorides, phosphates, imides, amides, borates, tosylate, tetrafluoroborate, hexafluoroborate, hexafluorophosphate, trifluoromethanesulfonate, methylsulfate, bis(pentafluoroethyl)phosphinate, thiocynate, octylsulfate, hexylsulfate, buthylsulfate, ethylsulfate, dicyanamide, hexafluoroantimonate, bis-(pentafluoroethyl)phospinate, bis-(trifluoromethyl)imide, trifluoroacetate and dicyanamide.

Preferably, the silicon salt to be used in the at least one silicon containing layer comprises silicon tetrachloride.

The electron conductive layer can suitably be a layer of a metal, a metal alloy, a semiconductor, an electron conductive polymer or a (transparent) conductive oxide.

The metal or metal alloy can suitably include aluminium, titanium, copper, steel, iron, nickel, silver, zinc, molybdenum, chromium or an alloy thereof. Preferably, aluminium or silver is used, or an alloy thereof.

The transparent conductive oxide may comprise one or more transparent conductive oxides selected from the group consisting of zinc oxide, tin oxide and/or indium tin oxide. Preferably, the transparent conductive oxide layer comprises zinc oxide and/or tin oxide. More preferably, the transparent conductive oxide layer comprises tin oxide.

Suitably, the electron conductive layer is an electron conductive substrate layer.

In a further embodiment of the present invention, a second silicon containing layer is applied onto the electron conductive layer. Preferably, such a second silicon containing layer is applied onto the first layer by means of electrodeposition from an ionic liquid, which ionic liquid comprises a dissolved silicon salt, and optionally a dopant in the form of a dissolved salt.

Preferably, the second silicon containing layer is directly applied onto the first silicon containing layer. However, one or more other layers may be applied between the first and second silicon containing layers. Such layers may comprise conducting, insulating or semiconducting materials.

In a preferred embodiment of the present invention, a third silicon containing layer is applied onto the electron conductive layer. Preferably, such a third silicon containing layer is applied onto the electron conductive layer by means of electrodeposition from an ionic liquid, which ionic liquid comprises a dissolved silicon salt, and optionally a dopant in the form of a dissolved salt.

Preferably, the third silicon containing layer is directly applied onto the second silicon containing layer. However, one or more other layers may be arranged between the second and third silicon containing layers. Such layers may comprise conducting, insulating or semiconducting materials.

In such embodiment, preferably, the first silicon containing layer comprises a donor and the third silicon containing layer comprises an acceptor or the first silicon containing layer comprises an acceptor and the third silicon containing layer comprises a donor, whereas the second silicon containing layer preferably comprises intrinsic or low doped silicon. In that way, a p-i-n structure or a n-i-p structure can be obtained.

In accordance with the present invention, at least two silicon containing layers can be applied onto the electron conductive layer, whereby at least one silicon layer is applied by means of electrodeposition from an ionic liquid, which ionic liquid comprises a dissolved silicon salt and a dopant in the form of a dissolved salt. In such embodiment, preferably, a first silicon containing layer comprises a donor and a second silicon containing layer comprises an acceptor or the first silicon containing layer comprises an acceptor and the third silicon containing layer comprises a donor

Also in accordance with the present invention, at least three silicon containing layers are applied onto the electron conductive layer, whereby at least one silicon layer is applied by means of electrodeposition from an ionic liquid, which ionic liquid comprises a dissolved silicon salt and a dopant in the form of a dissolved salt.

The silicon containing layers can suitably be applied onto the substrate at a temperature in the range of from -100 to 400 °C.

In the present invention use is made of an ionic liquid. It will be known to the skilled person that ionic liquids are defined as molten salts (ionic melts) having a melting point below 100°C.

The ionic liquids that can suitably be used in accordance with the present invention may be chosen from the group consisting of monosubstitued imidazolium derivates, Disubstituted imidazolium derivates, trissubstitued imidazolium derivates, pyridinium derivates, pyrrolidinium derivates,phosphonium derivates, ammonium derivates, guanidinium derivates and isouronium derivates.

The present invention further relates to a solar cell comprising at least two silicon containing layers and a electron conductive layer, wherein at least one of the silicon containing layers is applied using a method in accordance with the present invention.

The present invention also relates to a solar cell comprising at least three silicon containing layers and a electron conductive layer, wherein at least one of the silicon containing layers is applied using a method in accordance with the present invention.

In addition, the present invention also relates to other (opto)electronic devices or structures containing one or more doped silicon based layers which are applied using a method in accordance with the present invention.

## Claims

1. A method for applying at least one silicon containing layer onto an electron conductive layer by means of electrodeposition from an ionic liquid, which ionic liquid comprises a dissolved silicon salt and a dopant in the form of a dissolved salt.

2. A method according to claim 1, wherein the dopant is an electron donor.

3. A method according to claim 1, wherein the dopant is an electron acce

4. A method according claim 2, wherein the donor comprises a salt of an element from the group V elements.

5. A method according to claim 3, wherein the acceptor comprises a salt of an element from the group III elements.

6. A method according to claim 4, wherein the element is P, As or Sb.

7. A method according to claim 5, wherein the element is Al or B.

8. A method according to any one of claims 1-7, wherein the silicon salt comprises silicontetrachloride.

9. A method according to any one of claims 1-8, wherein the electron conductive layer comprises a layer of a metal, a metal alloy, a semiconductor, a conductive polymer or a (transparent) conductive oxide.

10. A method according to any one of claims 1-9, wherein the electron conductive layer is an electron conductive substrate.

11. A method according to any one of claims 1-10, wherein subsequently a second silicon containing layer is applied onto the electron conductive layer by means of electrodeposition from an ionic liquid, which ionic liquid comprises a dissolved silicon salt.

12. A method according to claim 11, wherein the second silicon containing layer is directly applied onto the first silicon containing layer.

13. A method according to claim 11 or 12, wherein subsequently a third silicon containing layer is applied onto the electron conductive layer by means of electrodeposition from an ionic liquid, which ionic liquid comprises a dissolved silicon salt and a dopant in the form of a dissolved salt.

14. A method according to claim 13, wherein the third silicon containing layer is directly applied onto the second silicon containing layer.

15. A method according to any one of claims 1-14, wherein at least two silicon containing layers are applied onto the electron conductive layer, whereby at least one silicon layer is applied by means of electrodeposition from an ionic liquid which liquid comprises a dissolved silicon salt and a dopant in the form of a dissolved salt.

16. A method according to claim 15, wherein a first silicon containing layer comprises a donor and a second silicon containing layer comprises an acceptor or the first silicum containing layer comprises an acceptor and the second silicon containing layer comprises a donor.

17. A method according to any one of claims 1-10, wherein at least three silicon containing layers are applied onto the electron conductive layer, whereby at least one silicon layer is applied by means of electrodeposition from an ionic liquid, whereby a first and a third silicon containing layer are prepared from an ionic liquid which comprises a dissolved silicon salt and a dopant in the form of a dissolved salt.

18. A method according to claim 17, wherein a first silicon containing layer comprises a donor and the third silicon containing layer comprises an acceptor or the first silicum containing layer comprises an acceptor and the third silicon containing layer comprises a donor.

19. A method according to claim 17 or 18, wherein a second silicon containing layer arranged between the first and third silicon containing layer comprises intrinsic or low doped silicon.

20. A solar cell comprising at least two silicon containing layers and a electron conductive substrate layer, wherein at least one of the silicon containing layers has been applied using a method as defined in any one of claims 1-19.

21. A solar cell comprising at least three silicon containing layers and a electron conductive substrate layer, wherein at least one of the silicon containing layers has been applied using a method as defined in any one of claims 1-19.
